# EUROPEAN PATENT SPECIFICATION

(11) **EP 4 365 613 B1**
(45) Date of publication and mention of the grant of the patent: **29.10.2025**
(21) Application number: 22876810.7
(22) Date of filing: 27.09.2022
(51) Int. Cl.: G01R 31/392, G01R 31/52, G01R 31/56, G01R 15/22, G01R 31/396, H02J 7/00, H01M 10/42, H01M 10/48

(54) **BATTERY PACK AND OPERATING METHOD THEREOF**
BATTERIEPACK UND BETRIEBSVERFAHREN DAFÜR
BLOC-BATTERIE ET SON PROCÉDÉ DE FONCTIONNEMENT

(30) Priority: 29.09.2021 KR 20210129269
(43) Date of publication of application: 08.05.2024
(73) Proprietor: LG Energy Solution, Ltd., Seoul 07335 (KR)
(72) Inventor: LEE, Jung Su, Daejeon 34122 (KR)
(74) Representative: Plasseraud IP
(86) International application number: PCT/KR2022/014473
(87) International publication number: WO 2023/055038

(56) References cited:
- JP-A- 2013 036 975
- JP-A- 2019 109 121
- KR-A- 20070 104 984
- KR-A- 20180 052 320
- KR-B1- 101 628 942
- US-A1- 2004 041 569
- US-A1- 2011 156 650
- US-A1- 2018 224 506
- US-A1- 2020 103 466

## Description

### [TECHNICAL FIELD]

### CROSS-REFERENCE TO RELATED APPLICATION

This application claims priority to and the benefit of Korean Patent Application No. 10-2021-0129269 filed in the Korean Intellectual Property Office on September 29, 2021.

### TECHNICAL FIELD

Embodiments disclosed herein relate to a battery pack and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

In a battery management apparatus, to accurately measure a voltage of battery cells, a line for receiving power from a battery and a voltage sensing line of each of the battery cells are separated. When the line for receiving power from the battery is disconnected during use of the battery management apparatus, the battery management apparatus stops operating, such that the use of the entire battery pack may be stopped. Thus, the battery management apparatus may be designed to receive power through another line even when a power supply line is disconnected.

US 2004/041569 A1 describes a battery pack comprising means for detecting a disconnection of nongrounding voltage detecting lines.

### [DISCLOSURE]

### [TECHNICAL PROBLEM]

Embodiments disclosed herein aim to provide a battery pack and an operating method thereof in which disconnection of a line for supplying power to a battery management apparatus from a battery may be sensed. The invention is set out in the appended set of claims.

Technical problems of the embodiments disclosed herein are not limited to the above-described technical problems, and other unmentioned technical problems would be clearly understood by one of ordinary skill in the art from the following description.

### [TECHNICAL SOLUTION]

A battery pack according to an embodiment disclosed herein includes a battery cell, a battery management apparatus connected to the battery cell through a first line and a second line, a detecting unit configured to detect current of a third line that connects the first line with the second line, and a determining unit configured to determine whether disconnection of the first line occurs, based on whether the current of the third line is detected.

In an embodiment, the detecting unit may include a photo-coupler and a diode included in the photo-coupler is connected to the third line.

In an embodiment, the determining unit may be further configured to determine that the first line is disconnected when current flows through the photo-coupler.

In an embodiment, the determining unit may include a micro-controller unit (MCU).

The battery management apparatus is further configured to receive power through the first line and to receive power through the third line when the first line is disconnected.

In an embodiment, a resistor may be connected to the first line and the second line.

In an embodiment, the first line may be a first power supply line, the second line may be a voltage sensing line, and the third line may be a second power supply line.

In an embodiment, the first line may be a first ground line of the battery management apparatus, the second line may be a voltage sensing line of the battery cell, and the third line may be a second ground line of the battery management apparatus.

In an embodiment, the battery cell may be provided in plural, and the second line may be a voltage sensing line of a lowermost battery cell among the plurality of battery cells.

In an embodiment, the battery cell may be provided in plural, and the second line is a voltage sensing line of an uppermost battery cell among the plurality of battery cells.

An operating method of a battery pack according to an embodiment disclosed herein includes detecting current of a third line connecting a first line with a second line, the first line and the second line connecting a battery cell with a battery management apparatus and determining whether disconnection of the first line occurs, based on the detected current of the third line, in which the battery management apparatus receives power through the first line and receives power through the third line when the first line is disconnected.

In an embodiment, the determining of whether disconnection of the first line occurs, based on the detected current of the third line, may include determining whether current flows through a photo-coupler and determining that disconnection of the first line occurs when determining that the current flows through the photo-coupler.

In an embodiment, the battery cell may be provided in plural, and the second line may be a voltage sensing line of an uppermost battery cell among the plurality of battery cells.

### [ADVANTAGEOUS EFFECTS]

A battery pack and an operating method thereof according to an embodiment disclosed herein may determine disconnection of a power supply line of a battery management apparatus by detecting current flowing to a line for supplying power to the battery management apparatus from a voltage sensing line of an uppermost battery cell.

The battery pack and the operating method thereof according to an embodiment disclosed herein may perform management to prevent use of a battery pack from being stopped even when the line for supplying power to the battery management apparatus is disconnected.

The battery pack and the operating method thereof according to an embodiment disclosed herein may determine disconnection more accurately than a technique for determining disconnection of the line for supplying power to the battery management apparatus through a sensing voltage drop of an uppermost battery cell.

Moreover, various effects recognized directly or indirectly from the disclosure may be provided.

### [DESCRIPTION OF DRAWINGS]

FIG. 1 illustrates a battery pack according to an embodiment disclosed herein.
FIG. 2 is a diagram showing a battery pack according to an embodiment disclosed herein.
FIG. 3 is a block diagram showing in detail a battery pack according to an embodiment disclosed herein.
FIG. 4 is a diagram showing a battery pack according to another embodiment disclosed herein.
FIG. 5 is a flowchart illustrating an operating method of a battery pack according to an embodiment disclosed herein.
FIG. 6 is a flowchart illustrating in more detail an operating method of a battery pack according to an embodiment disclosed herein.
FIG. 7 is a block diagram showing a hardware configuration of a computing system for performing a control method of a battery pack according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

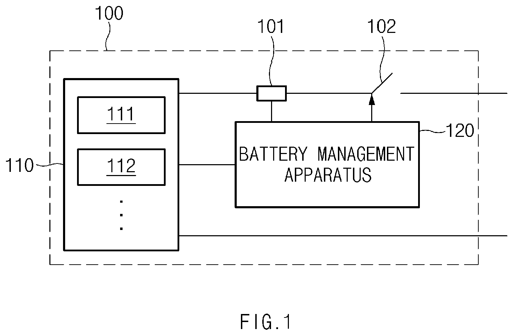

FIG. 1 illustrates a battery pack according to an embodiment disclosed herein.

Referring to FIG. 1, a battery pack 100 according to an embodiment disclosed herein may include a sensor 101, a switching unit 102, a battery module 110, and a battery management apparatus 120. In an embodiment, the battery pack 100 may include the sensor 101, the switching unit 102, the battery module 110, and the battery management apparatus 120 provided in plural.

The battery module 110 may include one or more chargeable/dischargeable battery cells. The battery module 110 may include a plurality of battery cells 111 and 112. For example, the battery module 110 may include n battery cells (n is a natural number greater than or equal to 2). The battery module 110 may supply power to a target device (not shown). To this end, the battery module 110 may be electrically connected to the target device. Herein, the target device may include an electrical, electronic, or mechanical device that operates by receiving power from the battery pack 100 including the plurality of battery cells 111 and 112.

The plurality of battery cells 111 and 112 may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 110 is illustrated in FIG. 1, the battery module 110 may be configured in plural according to an embodiment, and the plurality of battery modules may be connected in series or in parallel.

The sensor 101 may detect current flowing in the battery pack 100. In this case, a detected signal of current may be transmitted to the battery management apparatus 120.

The relay 102 may be connected in series to a (+) terminal side or a (-) terminal side of the battery module 110 to control the charging/discharging current flow of the battery module 110. For example, the relay 102 may use at least one relay, a magnetic contactor, etc., according to the specifications of the battery pack 100.

The battery management apparatus 120 may monitor the voltage, current, temperature, etc., of the battery pack 100 to perform control and management to prevent overcharging and overdischarging, etc., and may include, for example, a BMS.

The battery management apparatus 120, which is an interface for receiving measurement values of various parameter values, may include a plurality of terminals and a circuit, etc., connected to the terminals to process received values. The battery management apparatus 120 may control ON/OFF of the relay 102, and may be connected to the battery module 110 to monitor a state of the battery module 110.

The battery management apparatus 120 may manage and/or control a state and/or an operation of the battery module 110. For example, the battery management apparatus 120 may manage and/or control the states and/or operations of the plurality of battery cells 111 and 112 included in the battery module 110. The battery management apparatus 120 may manage charging and/or discharging of the battery module 110.

In addition, the battery management apparatus 120 may monitor a voltage, a current, a temperature, an insulating resistance, etc., of each of the battery cells 111 and 112 included in the battery pack 100. A sensor or various measurement modules for monitoring performed by the battery management apparatus 120, which are not shown, may be additionally installed in a charging/discharging path, any position of the battery module 110, etc. The battery management apparatus 120 may calculate a parameter indicating a state of the battery module 110, e.g., a state of charge (SoC), a state of health (SoH) etc., based on a measurement value such as monitored voltage, current, temperature, etc.

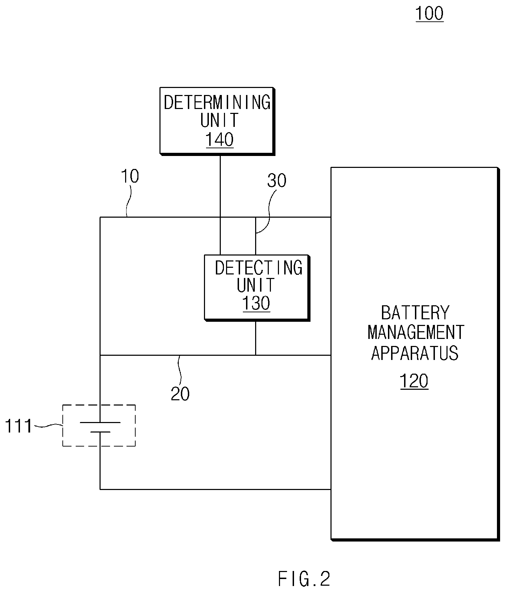

FIG. 2 is a block diagram showing a battery pack according to an embodiment disclosed herein.

Referring to FIG. 2, the battery pack 100 according to an embodiment disclosed herein may include the battery module 111, the battery management apparatus 120, a detecting unit 130, and a determining unit 140. In an embodiment, the battery pack 100 may be substantially the same as the battery pack 100 of FIG. 1, the battery cell 111 may be included in the battery module 110 of FIG. 1, and the battery management apparatus 120 may be substantially the same as the battery management apparatus 120 of FIG. 1.

The battery cell 111 may be included in the battery module 110 of FIG. 1. For example, the battery module 110 may include a plurality of battery cells.

The battery management apparatus 120 may be connected with the battery cell 111 through a first line 10 and a second line 20. For example, the first line 10 may be a power supply line of the battery management apparatus 120. In another example, the second line 20 may be a voltage sensing line of the battery cell 111. That is, the battery management apparatus 120 may be supplied with power from the battery module 110 through the first line 10. In an embodiment, the battery management apparatus 120 may operate with power supplied from the battery module 110 through the first line 10, and may not be able to receive power from the battery module 110 through the first line 10 when the first line 10 is disconnected.

The detecting unit 130 may detect current of a third line 30 connecting the first line 10 with the second line 20. For example, the third line 30 may be a line for supplying power to the battery management apparatus 120 when the first line 10 is disconnected. In another example, the third line 30 may be a second power supply line. In an embodiment, the detecting unit 130 may be connected to the third line 30.

The determining unit 140 may determine whether disconnection of the first line 10 occurs, based on the current of the third line 30 detected by the detecting unit 130. For example, the determining unit 140 may determine that disconnection occurs in the first line 10, when it is detected that the current flows through the third line 30. In another example, the determining unit 140 may determine that disconnection does not occur in the first line 10, when it is determined that the current does not flow through the third line 30.

In an embodiment, the battery cell 111 may be an uppermost battery cell among a plurality of battery cells included in the battery module 110 (see FIG. 1). In this case, the first line 120 may be a line for supplying power to the battery management apparatus 120 from the battery module 110, the second line 20 may be a line for sensing a voltage of the uppermost battery cell, and the third line 30 may be a line for supplying power to the battery management apparatus 120 when the first line 10 is disconnected.

The battery pack 100 according to an embodiment disclosed herein may determine disconnection of the first line 10 that is a line for supplying power to the battery management apparatus 120, by detecting whether the current flow through the third line 30. Thus, the battery pack 100 may determine disconnection of the first line 10 more accurately than a method of determining disconnection of the first line 10 based on reduction of a sensing voltage of the uppermost battery cell 111 in case of disconnection of the first line 10. Moreover, in the battery pack 100, the determining unit 140 may determine disconnection of the first line 10 based on detection by the detecting unit 130 of whether the current flows through the third line 30, thereby more accurately detecting disconnection of a line for supplying power to the battery management apparatus 120 and efficiently managing the battery pack 100.

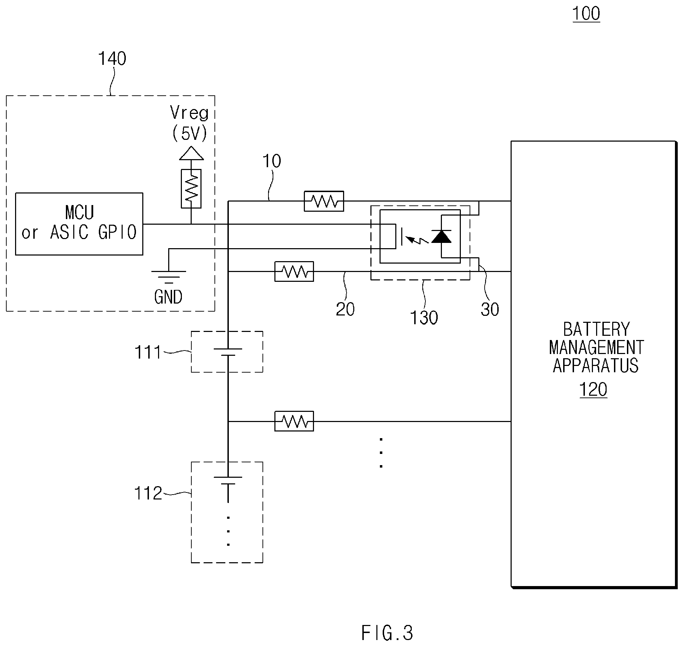

FIG. 3 is a block diagram showing in detail a battery pack according to an embodiment disclosed herein.

Referring to FIG. 3, the battery module 110 (see FIG. 1) may include the plurality of battery cells 111 and 112. For example, the uppermost battery cell 111 and the other battery cell 112 may be connected in series. In an embodiment, the uppermost battery cell 111 may be substantially the same as the battery cell 111 of FIG. 2.

The battery management apparatus 120 may be connected with the uppermost battery cell 111 through the first line 10 and the second line 20. For example, the first line 10 may be a line for supplying power to the battery management apparatus 120, and the second line 20 may be a line for sensing the voltage of the uppermost battery cell 111. In another example, a resistor may be connected to the first line 10 and the second line 20. In an embodiment, a resistor may be connected to a line for connecting the other battery cell 112 to the battery management apparatus 120.

The first line 10 and the second line 20 may be connected through the third line 30. For example, the third line 30 may be a line for supplying power to the battery management apparatus 120 when the first line 10 is disconnected.

The detecting unit 130 may detect the current of the third line 30. For example, the detecting unit 130 may include a photo-coupler, and a diode included in the photo-coupler may be connected to the third line 30. That is, the detecting unit 130 may detect the current flowing through the third line 30 through the photo-coupler. For example, when the current flows through the third line 30, the diode connected to the third line 30 may generate light and current may flow through photo-coupler when the light generated in the diode is detected.

The determining unit 140 may determine whether disconnection of the first line 10 occurs, based on the current of the third line 30 detected by the detecting unit 130. For example, the determining unit 140 may determine that the first line 10 is disconnected, when the current flows through the photo-coupler included in the detecting unit 130. That is, when the first line 10 is disconnected, the battery management apparatus 120 may receive power through the third line 30, and in this case, current may flow through the photo-coupler and the determining unit 140 may determine that the first line 10 is disconnected, by detecting the current flowing through the photo-coupler.

In an embodiment, the determining unit 140 may include a micro controller unit (MCU). The MCU may determine whether the current flows through the photo-coupler. For example, when the current flows through the photo-coupler, a voltage drop may occur from a reference voltage, and the MCU may detect that the current flows through the photo-coupler by detecting the voltage drop. In another example, when the current does not flow through the photo-coupler, a voltage drop may not occur from the reference voltage, and the MCU may detect that the current does not flow through the photo-coupler. The MCU may determine that the first line 10 is disconnected when it is detected that the current flows through the photo-coupler, and may determine that the first line 10 is not disconnected when it is detected that the current does not flow through the photo-coupler.

In an embodiment, the MCU may output information regarding disconnection of the first line 10 to the user when it is determined that the first line 10 is disconnected. Thus, the battery pack 100 may manage a power supply line of the battery management apparatus 120.

In an embodiment, the determining unit 140 may include an ASIC GPIO.

In an embodiment, the determining unit 140 may be included in the battery management apparatus 120. For example, the battery management apparatus 120 may determine whether the first line 10 is disconnected. In another example, when determining that the first line 10 is disconnected, the battery management apparatus 120 may transmit information about disconnection of the first line 10 to a higher-level controller (not shown).

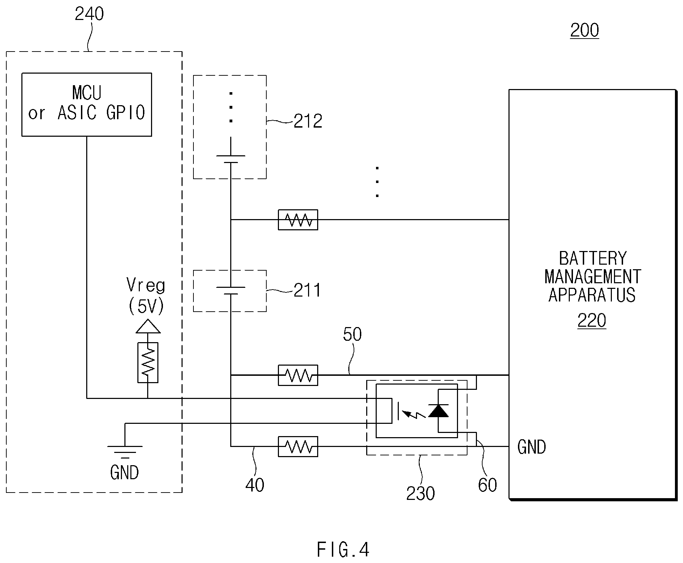

FIG. 4 is a diagram showing a battery pack according to another embodiment disclosed herein.

Referring to FIG. 4, a battery pack 200 according to another embodiment disclosed herein may include a plurality of battery cells 211 and 212, a battery management apparatus 220, a detecting unit 230, and a determining unit 240. In an embodiment, the battery management apparatus 220 may be substantially the same as the battery management apparatus 120 of FIG. 2.

The battery module 110 (see FIG. 1) may include the plurality of battery cells 211 and 212. For example, a lowermost battery cell 211 and the other battery cell 212 may be connected in series. In an embodiment, the lowermost battery cell 211 may be substantially the same as the battery cell 111 of FIG. 2.

The battery management apparatus 220 may be connected with the lowermost battery cell 211 through the first line 40 and the second line 50. For example, the first line 40 may be a line connected to a ground of the battery management apparatus 220, and the second line 50 may be a line for sensing the voltage of the lowermost battery cell 211. In an embodiment, the second line 50 may be a line connected to a (-) pole of the lowermost battery cell 211 for sensing the voltage of the lowermost battery cell 211. In an embodiment, a resistor may be connected to the first line 40 and the second line 50. In an embodiment, a resistor may be connected to a line for connecting the other battery cell 212 to the battery management apparatus 220.

The first line 40 and the second line 50 may be connected through the third line 60. For example, the third line 60 may be a line connected to a ground of the battery management apparatus 220 when the first line 40 is disconnected. In an embodiment, the first line 40 may be a first ground line of the battery management apparatus 220, the second line 50 may be a voltage sensing line of the lowermost battery cell 211, and the third line 60 may be a second ground line of the battery management apparatus 220.

The detecting unit 230 may detect the current of the third line 60. For example, the detecting unit 230 may include a photo-coupler, and a diode included in the photo-coupler may be connected to the third line 60. That is, the detecting unit 230 may detect the current flowing through the third line 60 through the photo-coupler. For example, when the current flows through the third line 60, the diode connected to the third line 60 may generate light and current may flow through photo-coupler when the light generated in the diode is detected.

The determining unit 240 may determine whether disconnection of the first line 40 occurs, based on the current of the third line 60 detected by the detecting unit 230. For example, the determining unit 240 may determine that the first line 40 is disconnected, when the current flows through the photo-coupler included in the detecting unit 230.

In an embodiment, the determining unit 240 may include an MCU. The MCU may determine whether the current flows through the photo-coupler. For example, when the current flows through the photo-coupler, a voltage drop may occur from a reference voltage, and the MCU may detect that the current flows through the photo-coupler by detecting the voltage drop. In another example, when the current does not flow through the photo-coupler, a voltage drop may not occur from the reference voltage, and the MCU may detect that the current does not flow through the photo-coupler. The MCU may determine that the first line 40 is disconnected when it is detected that the current flows through the photo-coupler, and may determine that the first line 40 is not disconnected when it is detected that the current does not flow through the photo-coupler.

In an embodiment, the MCU may output information regarding disconnection of the first line 40 to the user when it is determined that the first line 40 is disconnected. Thus, the battery pack 200 may manage a ground line of the battery management apparatus 220.

In an embodiment, the determining unit 240 may include an ASIC GPIO.

In an embodiment, the determining unit 240 may be included in the battery management apparatus 220. For example, the battery management apparatus 220 may determine whether the first line 40 is disconnected. In another example, when determining that the first line 40 is disconnected, the battery management apparatus 220 may transmit information about disconnection of the first line 40 to a higher-level controller (not shown).

Although not shown in FIGS. 3 and 4, a battery pack according to an embodiment disclosed herein may determine disconnection of a power supply line and a ground line of a battery management apparatus at the same time. For example, the battery pack according to an embodiment may include components shown in FIGS. 3 and 4.

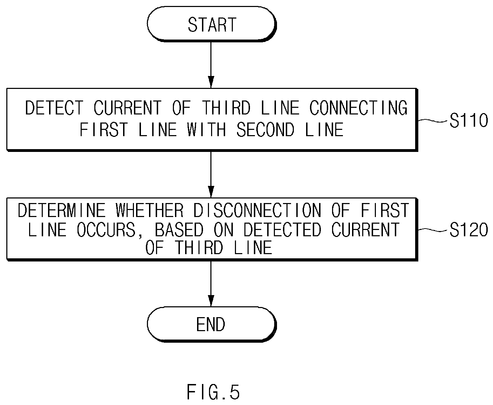

FIG. 5 is a flowchart illustrating an operating method of a battery pack according to an embodiment disclosed herein.

Referring to FIG. 5, an operating method of the battery pack 100 according to an embodiment disclosed herein may include operation S110 of detecting current of a third line connecting a first line with a second line and operation S 120 of determining whether disconnection of the first line occurs, based on the current of the third line.

In operation S 110 of detecting the current of the third line connecting the first line with the second line, the detecting unit 130 may detect the current of the third line 30 connecting the first line 10 with the second line 20. For example, the first line 10 may be a line for supplying power to the battery management apparatus 120, and the second line 20 may be a line for sensing the voltage of the uppermost battery cell by the battery management apparatus 120. In another example, the third line 30 may be a line for supplying power to the battery management apparatus 120 when the first line 10 is disconnected. That is, when the first line 10 is disconnected, the current may flow through the third line 30 to supply power to the battery management apparatus 120. In an embodiment, the detecting unit 130 may detect whether the current flows through the third line 30. In an embodiment, the detecting unit 130 may include a photo-coupler that may include a diode. In an embodiment, the battery cell may be provided in plural, and the second line 20 may be a voltage sensing line of the uppermost battery cell among the plurality of battery cells.

In operation S120 of determining whether disconnection of the first line occurs based on the current of the third line, the determining unit 140 may determine whether disconnection of the first line 10 occurs, based on the current of the third line 30. For example, the determining unit 140 may determine whether disconnection of the first line 10 occurs, based on the current of the third line 30 detected by the detecting unit 130. In another example, the determining unit 140 may determine that the first line 10 is disconnected when it is detected that the current flows through the third line 30, and may determine that the first line 10 is not disconnected when it is detected that the current does not flow through the third line 30. In an embodiment, the determining unit 140 may include an MCU.

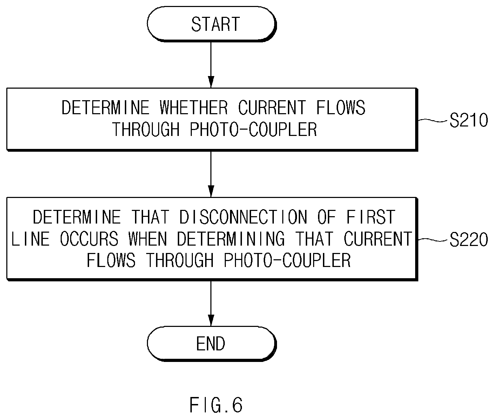

FIG. 6 is a flowchart illustrating in more detail an operating method of a battery pack according to an embodiment disclosed herein.

Referring to FIG. 6, an operating method of the battery pack 100 according to an embodiment disclosed herein may include operation S210 of determining whether current flows through the photo-coupler and operation S220 of determining that disconnection of the first line occurs when determining that the current flows through the photo-coupler. In an embodiment, operations S210 and S220 may be included in operation S120 of FIG. 5.

In operation S210 of determining whether the current flows through the photo-coupler, the determining unit 140 may determine whether the current flows through the photo-coupler. For example, when the current flows through the third line 30, the current may flow through the diode connected to the third line 30, and thus the diode may generate light, and the photo-coupler may detect the light generated in the diode, and thus the current may flow through the photo-coupler. In this case, when the current flows through the photo-coupler, the voltage drop may occur from the reference voltage, and the determining unit 140 may detect the voltage drop and thus determine that the current flows through the photo-coupler.

In operation S220 of determining that disconnection of the first line occurs when determining that the current flows through the photo-coupler, the determining unit 140 may determine that disconnection of the first line 10 occurs when determining that the current flows through the photo-coupler. For example, when the first line 10 is disconnected, the current may flow through the third line 30 and the current may flow through the photo-coupler, such that the determining unit 140 may determine that disconnection of the first line 10 occurs when determining that the current flows through the photo-coupler.

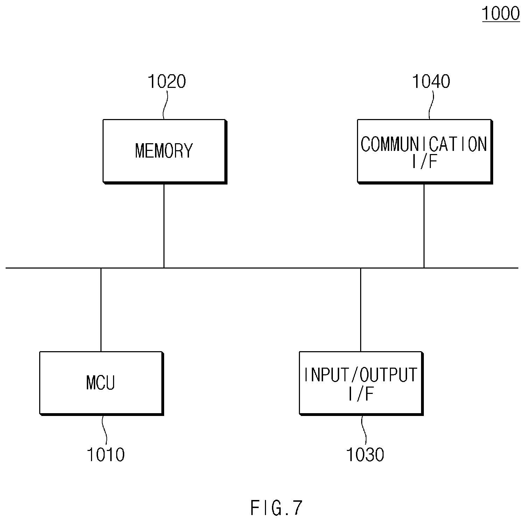

FIG. 7 is a block diagram showing a hardware configuration of a computing system for performing a control method of a battery management apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a battery cell voltage measurement program, a switching control program, etc.) stored in the memory 1020, processes various data including voltage, internal resistance, etc., of a battery cell through these programs, detects disconnection of a power supply line, and performs the above-described functions of the battery pack 100 or the determining unit 140 shown in FIG. 2.

The memory 1020 may store various programs regarding voltage measurement, switching control, etc., of the battery cell. Moreover, the memory 1020 may store various data such as a voltage, an internal resistance, etc., of the battery cell.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, a program for voltage measurement and switching control for a battery cell, various data, etc., may be transmitted and received to and from a separately provided external server through the communication I/F 1040.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

## Claims

1. A battery pack (100, 200) comprising:
a battery cell (111, 112, 211, 212);
a battery management apparatus (120, 220) connected to the battery cell (111, 112, 211, 212) through a first line (10, 40) and a second line (20, 50);
a detecting unit (130, 230) configured to detect current of a third line (30, 60) that connects the first line (10, 40) with the second line (20, 50); and
a determining unit (140, 240) configured to determine whether disconnection of the first line (10, 40) occurs, based on whether the current of the third line (30, 60) is detected;
**characterised in that**
the battery management apparatus (120, 220) is further configured to receive power through the first line (10, 40) and to receive power through the third line (30, 60) when the first line (10, 40) is disconnected.

2. The battery pack of claim 1, wherein the detecting unit (130, 230) comprises a photo-coupler and a diode included in the photo-coupler is connected to the third line (30, 60).

3. The battery pack of claim 2, wherein the determining unit (140, 240) is further configured to determine that the first line (10, 40) is disconnected when current flows through the photo-coupler.

4. The battery pack of claim 1, wherein the determining unit (140, 240) comprises a micro-controller unit (MCU) (1010).

5. The battery pack of claim 1, wherein the determining unit (140, 240) is included in the battery management apparatus (120, 220).

6. The battery pack of claim 1, wherein a resistor is connected to the first line (10, 40) and the second line (20, 50).

7. The battery pack of claim 1, wherein the first line (10, 40) is a first power supply line, the second line (20, 50) is a voltage sensing line, and the third line (30, 60) is a second power supply line.

8. The battery pack of claim 1, wherein the first line (10, 40) is a first ground line of the battery management apparatus (120, 220), the second line (20, 50) is a voltage sensing line of the battery cell (111, 112, 211, 212), and the third line (30, 60) is a second ground line of the battery management apparatus (120, 220).

9. The battery pack of claim 1, wherein the battery cell (111, 112, 211, 212) is provided in plural, and the second line (20, 50) is a voltage sensing line of an uppermost battery cell (112, 212) among the plurality of battery cells (111, 112, 211, 212).

10. The battery pack of claim 1, wherein the battery cell (111, 112, 211, 212) is provided in plural, and the second line (20, 50) is a voltage sensing line of a lowermost battery cell (111, 211) among the plurality of battery cells (111, 112, 211, 212).

11. An operating method of a battery pack (100, 200), the operating method comprising:
detecting (S110) current of a third line (30, 60) connecting a first line (10, 40) with a second line (20, 50), the first line (10, 40) and the second line (20, 50) connecting a battery cell (111, 112, 211, 212) with a battery management apparatus (120, 220); and
determining (S120) whether disconnection of the first line (10, 40) occurs, based on the detected current of the third line (30, 60),
**characterised in that**
the battery management apparatus (120, 220) receives power through the first line (10, 40) and receives power through the third line (30, 60) when the first line (10, 40) is disconnected.

12. The operating method of claim 11, wherein the determining of whether disconnection of the first line (10, 40) occurs, based on the detected current of the third line (30, 60), comprises:
determining (S210) whether current flows through a photo-coupler; and
determining (S220) that disconnection of the first line (10, 40) occurs when determining that the current flows through the photo-coupler.

13. The operating method of claim 11, wherein the battery cell (111, 112, 211, 212) is provided in plural, and the second line (20, 50) is a voltage sensing line of an uppermost battery cell (112, 212) among the plurality of battery cells (111, 112, 211, 212).

## Patentansprüche

1. Batteriepack (100, 200), umfassend:
eine Batteriezelle (111, 112, 211, 212);
eine Batterie-Verwaltungsvorrichtung (120, 220), welche mit der Batteriezelle (111, 112, 211, 212) durch eine erste Leitung (10, 40) und eine zweite Leitung (20, 50) verbunden ist;
eine Detektionseinheit (130, 230), welche dazu eingerichtet ist, einen Strom einer dritten Leitung (30, 60) zu detektieren, welche die erste Leitung (10, 40) mit der zweiten Leitung (20, 50) verbindet; und
eine Bestimmungseinheit (140, 240), welche dazu eingerichtet ist, zu bestimmen,
ob eine Trennung der ersten Leitung (10, 40) auftritt, auf Grundlage dessen, ob der Strom der dritten Leitung (30, 60) detektiert wird;
**dadurch gekennzeichnet, dass**
die Batterie-Verwaltungsvorrichtung (120, 220) ferner dazu eingerichtet ist,
Leistung durch die erste Leitung (10, 40) zu erhalten und Leistung durch die dritte Leitung (30, 60) zu erhalten, wenn die erste Leitung (10, 40) getrennt ist.

2. Batteriepack nach Anspruch 1, wobei die Detektionseinheit (130, 230) einen Fotokoppler umfasst, und eine Diode, welche in dem Fotokoppler umfasst ist, mit der dritten Leitung (30, 60) verbunden ist.

3. Batteriepack nach Anspruch 2, wobei die Bestimmungseinheit (140, 240) ferner dazu eingerichtet ist, zu bestimmen, dass die erste Leitung (10, 40) getrennt ist, wenn ein Strom durch den Fotokoppler fließt.

4. Batteriepack nach Anspruch 1, wobei die Bestimmungseinheit (140, 240) eine Mikrocontroller-Einheit (MCU) (1010) umfasst.

5. Batteriepack nach Anspruch 1, wobei die Bestimmungseinheit (140, 240) in der Batterie-Verwaltungsvorrichtung (120, 220) umfasst ist.

6. Batteriepack nach Anspruch 1, wobei ein Widerstand mit der ersten Leitung (10, 40) und der zweiten Leitung (20, 50) verbunden ist.

7. Batteriepack nach Anspruch 1, wobei die erste Leitung (10, 40) eine erste Leistungsversorgung-Leitung ist, die zweite Leitung (20, 50) eine Spannung-Erfassungsleitung ist und die dritte Leitung (30, 60) eine zweite Leistungsversorgung-Leitung ist.

8. Batteriepack nach Anspruch 1, wobei die erste Leitung (10, 40) eine erste Erdungsleitung der Batterie-Verwaltungsvorrichtung (120, 220) ist, die zweite Leitung (20, 50) eine Spannung-Erfassungsleitung der Batteriezelle (111, 112, 211, 212) ist und die dritte Leitung (30, 60) eine zweite Erdungsleitung der Batterie-Verwaltungsvorrichtung (120, 220) ist.

9. Batteriepack nach Anspruch 1, wobei die Batteriezelle (111, 112, 211, 212) mehrfach bereitgestellt ist und die zweite Leitung (20, 50) eine Spannung-Erfassungsleitung einer obersten Batteriezelle (112, 212) unter der Mehrzahl von Batteriezellen (111, 112, 211, 212) ist.

10. Batteriepack nach Anspruch 1, wobei die Batteriezelle (111, 112, 211, 212) mehrfach bereitgestellt ist und die zweite Leitung (20, 50) eine Spannung-Erfassungsleitung einer untersten Batteriezelle (111, 211) unter der Mehrzahl von Batteriezellen (111, 112, 211, 212) ist.

11. Betriebsverfahren für einen Batteriepack (100, 200), wobei das Betriebsverfahren umfasst:
Detektieren (S110) eines Stroms einer dritten Leitung (30, 60), welche eine erste Leitung (10, 40) mit einer zweiten Leitung (20, 50) verbindet, wobei die erste Leitung (10, 40) und die zweite Leitung (20, 50) eine Batteriezelle (111, 112, 211, 212) mit einer Batterie-Verwaltungsvorrichtung (120, 220) verbinden; und Bestimmen (S120), ob ein Trennen der ersten Leitung (10, 40) auftritt, auf Grundlage des detektierten Stroms der dritten Leitung (30, 60),
**dadurch gekennzeichnet, dass**
die Batterie-Verwaltungsvorrichtung (120, 220) Leistung durch die erste Leitung (10, 40) erhält und Leistung durch die dritte Leitung (30, 60) erhält, wenn die erste Leitung (10, 40) getrennt ist.

12. Betriebsverfahren nach Anspruch 11, wobei das Bestimmen, ob ein Trennen der ersten Leitung (10, 40) auftritt, auf Grundlage des detektierten Stroms der dritten Leitung (30, 60) umfasst:
Bestimmen (S210), ob ein Strom durch einen Fotokoppler fließt; und
Bestimmen (S220), dass ein Trennen der ersten Leitung (10, 40) auftritt, wenn bestimmt wird, dass der Strom durch den Fotokoppler fließt.

13. Betriebsverfahren nach Anspruch 11, wobei die Batteriezelle (111, 112, 211, 212) mehrfach bereitgestellt ist und die zweite Leitung (20, 50) eine Spannung-Erfassungsleitung einer obersten Batteriezelle (112, 212) unter der Mehrzahl von Batteriezellen (111, 112, 211, 212) ist.

## Revendications

1. Bloc-batterie (100, 200) comprenant :
une cellule de batterie (111, 112, 211, 212) ;
un appareil de gestion de batterie (120, 220) connecté à la cellule de batterie (111, 112, 211, 212) par le biais d'une première ligne (10, 40) et d'une deuxième ligne (20, 50) ; une unité de détection (130, 230) configurée pour détecter le courant d'une troisième ligne (30, 60) qui connecte la première ligne (10, 40) à la deuxième ligne (20, 50) ; et une unité de détermination (140, 240) configurée pour déterminer si une déconnexion de la première ligne (10, 40) se produit, selon que le courant de la troisième ligne (30, 60) est détecté ou non ; **caractérisé en ce que** l'appareil de gestion de batterie (120, 220) est en outre configuré pour recevoir de l'énergie par le biais de la première ligne (10, 40) et pour recevoir de l'énergie par le biais de la troisième ligne (30, 60) lorsque la première ligne (10, 40) est déconnectée.

2. Bloc-batterie selon la revendication 1, dans lequel l'unité de détection (130, 230) comprend un photocoupleur et une diode incluse dans le photocoupleur est connectée à la troisième ligne (30, 60).

3. Bloc-batterie selon la revendication 2, dans lequel l'unité de détermination (140, 240) est en outre configurée pour déterminer que la première ligne (10, 40) est déconnectée lorsque le courant circule à travers le photocoupleur.

4. Bloc-batterie selon la revendication 1, dans lequel l'unité de détermination (140, 240) comprend une unité de microcontrôleur (MCU) (1010).

5. Bloc-batterie selon la revendication 1, dans lequel l'unité de détermination (140, 240) est incluse dans l'appareil de gestion de batterie (120, 220).

6. Bloc-batterie selon la revendication 1, dans lequel une résistance est connectée à la première ligne (10, 40) et à la deuxième ligne (20, 50).

7. Bloc-batterie selon la revendication 1, dans lequel la première ligne (10, 40) est une première ligne d'alimentation électrique, la deuxième ligne (20, 50) est une ligne de détection de tension et la troisième ligne (30, 60) est une deuxième ligne d'alimentation électrique.

8. Bloc-batterie selon la revendication 1, dans lequel la première ligne (10, 40) est une première ligne de masse de l'appareil de gestion de batterie (120, 220), la deuxième ligne (20, 50) est une ligne de détection de tension de la cellule de batterie (111, 112, 211, 212) et la troisième ligne (30, 60) est une deuxième ligne de masse de l'appareil de gestion de batterie (120, 220).

9. Bloc-batterie selon la revendication 1, dans lequel la cellule de batterie (111, 112, 211, 212) est fournie en plusieurs exemplaires, et la deuxième ligne (20, 50) est une ligne de détection de tension d'une cellule de batterie la plus haute (112, 212) parmi la pluralité de cellules de batterie (111, 112, 211, 212).

10. Bloc-batterie selon la revendication 1, dans lequel la cellule de batterie (111, 112, 211, 212) est fournie en plusieurs exemplaires, et la deuxième ligne (20, 50) est une ligne de détection de tension d'une cellule de batterie la plus basse (111, 211) parmi la pluralité de cellules de batterie (111, 112, 211, 212).

11. Procédé de fonctionnement d'un bloc-batterie (100, 200), le procédé de fonctionnement comprenant :
la détection (S110) d'un courant d'une troisième ligne (30, 60) connectant une première ligne (10, 40) à une deuxième ligne (20, 50), la première ligne (10, 40) et la deuxième ligne (20, 50) connectant une cellule de batterie (111, 112, 211, 212) à un appareil de gestion de batterie (120, 220) ; et le fait de déterminer (S120) si une déconnexion de la première ligne (10, 40) a lieu, sur la base du courant détecté de la troisième ligne (30, 60), **caractérisé en ce que** l'appareil de gestion de batterie (120, 220) reçoit de l'énergie par le biais de la première ligne (10, 40) et reçoit de l'énergie par le biais de la troisième ligne (30, 60) lorsque la première ligne (10, 40) est déconnectée.

12. Procédé de fonctionnement selon la revendication 11, dans lequel le fait de déterminer si une déconnexion de la première ligne (10, 40) a lieu, sur la base du courant détecté de la troisième ligne (30, 60), comprend :
le fait de déterminer (S210) si du courant circule à travers un photocoupleur ; et
le fait de déterminer (S220) que la déconnexion de la première ligne (10, 40) a lieu lorsqu'il est déterminé que le courant circule à travers le photocoupleur.

13. Procédé de fonctionnement selon la revendication 11, dans lequel la cellule de batterie (111, 112, 211, 212) est fournie en plusieurs exemplaires, et la deuxième ligne (20, 50) est une ligne de détection de tension d'une cellule de batterie la plus haute (112, 212) parmi la pluralité de cellules de batterie (111, 112, 211, 212).
